(19) **Europäisches Patentamt**

**European Patent Office**

**Office européen des brevets**

(11) **EP 1 005 734 B1**

(12) **EUROPÄISCHE PATENTSCHRIFT**

(45) Veröffentlichungstag und Bekanntmachung des Hinweises auf die Patenterteilung:
**17.04.2002   Patentblatt 2002/16**

(21) Anmeldenummer: **98948686.5**

(22) Anmeldetag: **29.07.1998**

(51) Int Cl.$^7$: **H04L 1/18**

(86) Internationale Anmeldenummer:
**PCT/DE98/02167**

(87) Internationale Veröffentlichungsnummer:
**WO 99/11011 (04.03.1999 Gazette 1999/09)**

(54) **VERFAHREN ZUR DATENÜBERTRAGUNG IN EINEM DIGITALEN ÜBERTRAGUNGSSYSTEM BEI PAKETVERMITTELTEM DIENST**

METHOD FOR DATA TRANSFER IN A DIGITAL TRANSMISSION SYSTEM WITH A PACKET-SWITCHING SERVICE

PROCEDE POUR LA TRANSMISSION DE DONNEES DANS UN SYSTEME DE TRANSMISSION NUMERIQUE EN SERVICE DE COMMUTATION DE PAQUETS

(84) Benannte Vertragsstaaten:
**DE DK FI FR GB IT SE**

(30) Priorität: **22.08.1997   DE 19736626**

(43) Veröffentlichungstag der Anmeldung:
**07.06.2000   Patentblatt 2000/23**

(73) Patentinhaber: **SIEMENS AKTIENGESELLSCHAFT 80333 München (DE)**

(72) Erfinder:
• **DOETSCH, Markus D-56072 Koblenz (DE)**
• **PLECHINGER, Jörg D-80469 München (DE)**
• **JUNG, Peter D-67697 Otterberg (DE)**
• **BERENS, Friedbert D-67663 Kaiserslautern (DE)**

(56) Entgegenhaltungen:
• **NARAYANAN K R ET AL: "A NOVEL ARQ TECHNIQUE USING THE TURBO CODING PRINCIPLE" IEEE COMMUNICATIONS LETTERS, Bd. 1, Nr. 2, März 1997, Seiten 49-51, XP000687091**
• **NASSHAN M ET AL: "New results on the application of antenna diversity and turbo-codes in a JD-CDMA mobile radio system" 5TH IEEE INTERNATIONAL SYMPOSIUM ON PERSONAL, INDOOR AND MOBILE RADIO COMMUNICATIONS (PIMRC'94), AND ICCC REGIONAL MEETING ON WIRELESS COMPUTER NETWORKS (WCN), THE HAGUE, THE NETHERLANDS, Bd. 2, 18. - 23. September 1994, Seiten 524-528, XP002091099 Amsterdam, IOS Press, Netherlands**
• **JUNG P: "COMPARISON OF TURBO-CODE DECODERS APPLIED TO SHORT FRAME TRANSMISSION SYSTEMS" IEEE JOURNAL ON SELECTED AREAS IN COMMUNICATIONS, Bd. 14, Nr. 3, 1. April 1996, Seiten 530-537, XP000586080 in der Anmeldung erwähnt**
• **NARAYANAN K R ET AL: "PHYSICAL LAYER DESIGN FOR PACKET DATA OVER IS-136" 1997 IEEE 47TH. VEHICULAR TECHNOLOGY CONFERENCE, PHOENIX, AZ, USA, Bd. 2, Nr. 47, 4. - 7. Mai 1997, Seiten 1029-1033, XP000736764 INSTITUTE OF ELECTRICAL AND ELECTRONICS ENGINEERS**

**Beschreibung**

Die Erfindung betrifft ein Verfahren zur Datenübertragung in einem digitalen Übertragungssystem bei paketvermitteltem Dienst, bei dem zur Kanalcodierung senderseitig in einem Turbo-Codierer eine Turbo-Codierung und empfängerseitig in einem Turbo-Decodierer eine Turbo-Decodierung mit Soft-Decision-Ausgangssignalen durchgeführt wird.

In P. Jung, "Comparison of Turbo-Code Decoders Applied to Short Frame Transmission Systems", IEEE Journal on Selected Areas in Communications, Band 14 (1996) Seiten 530 - 537 wird die Anwendung von Turbo-Codes für digitale Übertragungssysteme untersucht, wobei sowohl Codierer als auch Decodierer für die Turbocodes in der Übertragungsstrecke untersucht werden. Die Decodierung der Turbocodes beruht auf der Verwendung von Soft-Input/Soft-Output-Decodierern, die entweder unter Verwendung von MAP(Maximum a-posteriori)-Symbolschätzern oder von MAP-Sequenzschätzern, beispielsweise einem Schätzer mit einema-priori-Soft-Output-Viterbi-Algorithmus(APRI-SOVA) verwirklicht werden können. In dieser Veröffentlichung werden vier verschiedene Decodiereranordnungen und ihre Fähigkeiten, bestimmte Fehlerraten zu verarbeiten, beschrieben. Außerdem wird die Leistungsfähigkeit dieser Decoder bei verschiedenen Anwendungsfällen untersucht. Es wird festgestellt, daß die Turbocodes und deren iterative Decodierung eine wirksame Maßnahme gegen Paketfehler ist.

In ICC '95, Seattle, Washington, Juni 18-22, 1995, "Turbo Codes for BCS Applications", D. Divsalar und F. Pollara, werden Turbocodes vorgeschlagen, um eine Fehlerkorrektur bis nahe an die sogenannte Shannon-Grenze zu erreichen. Dazu sollen verhältnismäßig einfache Komponentencodes und große Interleaver verwendet werden. In dieser Veröffentlichung werden die Turbocodes in einem Codierer mit mehrfachen Codes erzeugt und in einem geeigneten Decodierer decodiert. Die Turbocodes wurden von Berrou et al. 1993 eingeführt (siehe C. Berrou, A. Glavieux und P. Thitimayshima, "Near Shannon limit area correction coding: Turbo codes" Proc. 1993 IEE International conference on communications, Seiten 1064-1070). Mit dieser Methode kann einerseits eine sehr gute Fehlerkorrektur erreicht werden.

Aus ETT European Transactions on Telecommunications, Vol. 6, No. 5, September-October 1995, "Iterative Correction of Intersymbol Interference: Turbo-Equalization", Catherine Douillard et al. ist die sogenannte Turbo-Entzerrung bekannt, mit der die nachteiligen Effekte der Intersymbolinterferenz bei digitalen Übertragungssystemen behoben werden sollen, die durch Faltungscodes geschützt sind. Der Empfänger führt zwei aufeinanderfolgende Soft-Output-Entscheidungen aus, die von einem Symboldetektor und einem Kanaldecodierer über einen iterativen Prozess durchgeführt werden. Bei jeder Iteration wird extrinsische Information aus dem Detektor und dem Decoder bei der nächsten Iteration wie bei der Turbode-codierung verwendet. Es wird gezeigt, daß mit der Turbo-Entzerrung Intersymbolinterferenzeffekte bei Mehrweg-Kanälen überwunden werden können.

Aus Narayanan K.R. et al, "A Novel ARQ Technique using the turbo coding priciple", IEEE Communications Letters, Bd. 1, Nr. 2, März 1997, S-49-51, und Nasshan M. et al, "New results on the application of antenna diversity and turbo-codes in a JD-CDMA mobile radio system, 5th IEEE International Symposium on personal, indoor and mobile radio communications (PIMRC'92), and ICCC Regional meeting on wireless computer networks (WCN), The Hague, Netherlands, Bd. 2, 18.-23.9.1994, S.524-528, sind Verfahren zur Verknüpfung von Turbo-Codierung, ARQ (automatic repeat request) und Funksystem bekannt.

Zukünftige Übertragungssysteme, beispielsweise das Europäische UMTS (Universal Mobile Telecommunications System) erfordern die Unterstützung einer Vielzahl von koexistierenden Trägerdiensten mit Trägerdatenraten von bis zu 2 Mbit/s in einer flexiblen Weise, wobei der bestmögliche spektrale Wirkungsgrad angestrebt wird. In dem ACTS (Advanced Communications Technologies and Services) Projekt AC090 FRAMES (Future Radio Wideband Multiple Access Systems) wurde ein MA(Multiple Access)-Schema entwikkelt, welches sich FRAMES Multiple Access(FMA) nennt und die Erfordernisse von UMTS erfüllt. Als Übertragungssystem der dritten Generation, welches einen weiten Bereich von Anwendungsgebieten, Trägerdiensten und unterschiedlichen Szenarios umfaßt, muß FMA gegenwärtige und zukünftige Entwicklungen von UMTS Funk-Interface-Standards zu erfüllen. FMA umfaßt zwei Betriebsarten, nämlich WB-TDMA (Wideband Time Division Multiple Access) mit und ohne Spreizung und Kompatibilität mit GSM (Global System for Mobile Communications) und WB-CDMA (Wideband Code Division Multiple Access). Obwohl hier im wesentlichen ein System nach FMA betrachtet wird, können auch andere Übertragungssysteme mit Vielfachzugriffsverfahren, beispielsweise FDMA (Frequenzy Division Multiple Access) oder MC-CDMA (Multicarier-CDMA) oder Kombinationen der erwähnten Übertragungssysteme einbezogen werden.

Im Hinblick auf die hohe Leistungsfähigkeit der Turbocodes ist es wünschenwert, diese bei digitalen Übertragungssystemen einzusetzen. Die vielfältigen Erfordernisse, beispielsweise bei FMA machen es jedoch erforderlich, beim Einsatz derartiger Turbocodes darauf zu achten, daß die Datenübertragung nicht durch die Übertragung von Fehlerkorrekturcodes zu stark belastet wird.

Der Erfindung liegt die Aufgabe zugrunde, die ein Verfahren zur Paketübertragung mit einem ARQ-Protokoll auf Übertragungskanälen in einem digitalen Übertragungssystem, bei dem zur Kanalcodierung eine Turbo-Codierung eingesetzt wird, bereitzustellen, bei dem durch einen neuen Turbo-Code und eine darauf abgestimmte Punktirung die Kanalbelastung durch ARQ möglichst gering gehalten werden kann.

Erfindungsgemäß ist dazu das eingangs erwähnte Verfahren dadurch gekennzeichnet, daß zur Auslösung eines ARQ

- die Kanalgüte durch ein an sich bekanntes Parameterschätzverfahren abgeschätzt wird, daß
- die Varianzen der Soft-Decision-Ausgangssignale an dem Turbo-Decodierer bestimmt werden, daß
- aus der Kanalgüte und den Varianzen auf die Korrektheit beziehungsweise Fehlerhaftigkeit des übertragenen Paketes geschlossen wird, und daß
- eine erneute Sendung wenigstens eines Teiles eines fehlerhaften Paketes ausgelöst wird.

Bisher wurde ein ARQ dadurch ausgelöst, daß das zu sendende Datenpaket durch eine geeignete, fehlererkennende Codierung, beispielsweise CRC (Cyclic Redundancy Check) geschützt wurde. Im Empfänger können dann durch diese Art der Codierung fehlerhafte Datenblöcke erkannt und erneut angefordert werden. Bei diesem Verfahren ist nachteilig, daß die fehlererkennende Codierung zusätzliche Redundanzbits erzeugt, mit denen keine Information übertragen werden kann. Demgegenüber hat das erfindungsgemäße Verfahren den Vorteil, daß zur Auslösung von ARQ auf die Abschätzung der Dienstqualität zurückgegriffen wird. Wie weiter unten im einzelnen dargelegt ist, kann in Abhängigkeit der Kanalgüte mit Hilfe der berechneten Varianz, beispielsweise der LLR's, für den decodierten Block eine eindeutige Aussage über die Korrektheit des Blocks beziehungsweise des Pakets gemacht werden. Zur Abschätzung der Kanalgüte wird hierzu eines der bekannten Parameterschätzverfahren, beispielsweise MMSE (Minimum Mean Square Error Estimation), MOM (Method of Moments) oder MVU (Minimum Variance Unbiased Estimation) eingesetzt. Bei der Erfindung entfällt somit die fehlererkennende Codierung des Datenpakets. Hierdurch erhöht sich die Gesamtcodierungsrate auf dem Übertragungskanal und damit auch der Anteil der im Paket enthaltenen Nutzinformation. Weiterhin wird der Rechenaufwand für die Decodierung verringert, und somit auch der durch die Decodierung des fehlererkennenden Anteils erzeugte Verzögerung.

Unter dem Begriff Dienstqualität wird hier folgendes verstanden. Für verschiedene Dienste gelten bestimmte QoS-Kriterien (QoS = Quality of Service = Dienstqualität), und die Definitionen der QoS-Kriterien für verschiedene Trägerdienste sind im Rahmen von FRAMES ausgearbeitet worden. Ein wichtiger Bestandteil eines QoS-Kriteriums ist die Trägerdatenrate R. Das QoS-Kriterium umfaßt auch eine maximal zulässige Fehlerrate $P_b^G$ oder eine Paketverlustrate $P_l^G$ in Kombination mit einer maximalen Ausfallwahrscheinlichkeit $P_{out}^G$. Im Falle von leistungsvermittelten Diensten muß die Wahrscheinlichkeit $P\{P_b > P_b^G\}$, daß die augenblickliche Bitfehlerrate $P_b$ die $P_b^G$ übersteigt, nicht größer sein als $P_{out}^G$, das heißt

$$Pr\{P_b > P_b^G\} < P_{out}^G.$$

Bei Sprachübertragung ist $P_b^G$ gleich $10^{-3}$ und $P_{out}^G$ gleich 0,05. Bei Paketdiensten gilt eine ähnliche Bedingung für die augenblickliche Paketverlustrate $P_l$:

$$Pr\{P_l > P_l^G\} < P_{out}^G.$$

Außer den Kriterien bezüglich Pr gibt es noch weitere Bedingungen im Rahmen des QoS-Kriteriums. Hier werden jedoch hauptsächlich die QoS-Parameter $P_b^G$, $P_l^G$ und $P_{out}^G$ betrachtet, die unmittelbar mit der Wahl des Fehlerkorrekturcodes (ECC) zu tun haben. Bei ECC bestimmen das Vielfachzugriffsverfahren, die Modulation und die Paketparameter im wesentlichen die Codierungsrate $R_c$. Mit anderen Worten hat die Codierungsrate $R_c$ einen unmittelbaren Zusammenhang mit der Frage, ob ein QoS-Kriterium für einen bestimmten Dienst erfüllt wird oder nicht.

Bei einem Verfahren, bei dem empfängerseitig ein Soft-Input/Soft-Output- Symbol oder -Sequenzschätzer verwendet wird, ist es vorteilhaft, wenn die Dienstqualität aus den Varianzen $\sigma^2$ der Soft-Decision-Ausgangssignale des Turbo-Decodierers bestimmt wird, wobei vorteilhafterweise aus den Varianzen $\sigma^2$ die Bitfehlerrate als Maß für die Dienstqualität berechnet wird.

Bei einem Verfahren, bei dem empfängerseitig ein MAP-Symbolschätzer oder ein MAP-Sequenzschätzer verwendet wird, ist es vorteilhaft, wenn die Dienstqualität aus den Varianzen $\sigma^2_{LLR}$ der Soft-Decision-Ausgangssignale des Turbo-Decodierers bestimmt wird.

Bei einem Verfahren, bei dem empfängerseitig ein Viterbi-Algorithmus zur Seqenzschätzung verwendet wird, ist es vorteilhaft, wenn die Dienstqualität aus den Varianzen $\sigma^2_{VIT}$ der Soft-Decision-Ausgangssignale des Turbo-Decodierers bestimmt wird.

Da das erfindungsgemäße Verfahren sowohl bei MAP-Schätzern als auch bei einer Schätzung durch einen Viterbi-Algorithmus einsetzbar ist, gibt es praktisch keine Einschränkung bezüglich der wichtigsten Verfahren zur Sequenz- und Symbolschätzung. Dies gilt, obwohl in der folgenden speziellen Beschreibung diese Aussage nur im Zusammenhang mit einem MAP-Symbolschätzer belegt wird.

Nach einer vorteilhaften Ausgestaltung ist das erfindungsgemäße Verfahren, dadurch gekennzeichnet, daß zur Punktierung die sogenannte Berrou's Punktierung eingesetzt wird, bei der nur die nicht-systematische Information punktiert wird. Diese Art der Punktierung ist bei geringeren Werten des Signal/Rausch-Verhältnisses vorteilhaft.

Nach einer vorteilhaften Ausgestaltung ist das erfindungsgemäße Verfahren dadurch gekennzeichnet, daß zur Punktierung die sogenannte UKL-Punktierung eingesetzt wird, bei der sowohl die systematische als auch die nicht-systematische Information punktiert wird. Diese Art der Punktierung ist vorteilhaft bei höheren Signal/Rausch-Verhältnissen und daher bei Bitfehlerraten von < $10^{-4}$.

Nach einer vorteilhaften Ausgestaltung ist das erfindungsgemäße Verfahren, dadurch gekennzeichnet, daß als Turbo-Code ein RCPTC verwendet wird. Wie aus der detaillierten Beschreibung ersichtlich wird, ist ein derartiger Code besonders flexibel und geeignet für die Zwecke der Erfindung. Der RCPTC ermöglicht den Übergang von festgelegten ECC-auf flexible ECC-Strategien, wobei letztere auf zeitlich variierende Erfordernisse abgestimmt sind, so daß eine flexible Linklayer-Kontrolle und Medium-Zugriffskontrolle möglich ist.

Nach einer vorteilhaften Ausgestaltung ist das erfindungsgemäße Verfahren, dadurch gekennzeichnet, daß bei einer erneuten Übertragung der Information eines fehlerhaften Paketes wenigstens ein Teil der durch die Punktierung des RCPTC's bei der vorherigen Sendung unterdrückten Information gesendet wird, und daß diese zusätzliche Information empfängerseitig in die bereits vorhandene Information eingefügt und diese vollständige Information erneut decodiert wird. Dadurch wird der Kanal beim Einsatz eines ARQ-Verfahren so wenig wie möglich belastet.

Nach einer vorteilhaften Ausgestaltung ist das erfindungsgemäße Verfahren dadurch gekennzeichnet, daß bei der erneuten Sendung nur die Bits gesendet werden, die bei der nächst niedrigeren Codierungsrate zusätzlich zur Verfügung stehen, da sie nicht punktiert werden. Dadurch wird nur die minimal erforderliche Information übertragen, um das Ziel einer angemessenen Übertragungsqualität zu erreichen.

Nach einer vorteilhaften Ausgestaltung ist das erfindungsgemäße Verfahren dadurch gekennzeichnet, daß das Verfahren wiederholt wird, bis eine fehlerfreie Decodierung des Pakets erfolgt ist oder die gesamte codierte Information eines Pakets übertragen ist. Damit wird auf jeden Fall das gesamte Potential der Codierung ausgeschöpft, um die Fehler in einem Paket zu korrigieren.

Ausführungsbeispiele der Erfindung werden nun anhand der beiliegenden Zeichnungen beschrieben. Es zeigen:

Figur 1  ein Blockdiagramm eines Turbo-Codierers;

Figur 2  ein Blockdiagramm eines RSC-Codierers, wie er in einem Turbo-Codierer nach Figur 1 verwendet wird;

Figur 3  ein Blockdiagramm eines Turbo-Decodierers;

Figur 4  eine graphische Darstellung zur Leistungsfähigkeit eines RCPTC's bei einem AWGN-Kanal in Abhängigkeit von der Zahl der Iterationen bei der Turbo-Decodierung;

Figur 5  eine graphische Darstellung der Leistungsfähigkeit eines RCPTC's bei einem Rayleigh-Kanal bei verschiedener Anzahl von Iterationen bei der Turbo-Decodierung;

Figur 6  eine graphische Darstellung der Leistungsfähigkeit eines RCPTC's bei einem AWGN-Kanal in Abhängigkeit von unterschiedlichen Codierungsraten;

Figur 7  eine graphische Darstellung der Leistungsfähigkeit eines RCPTC's bei einem Rayleigh-Kanal in Abhängigkeit von verschiedenen Codierungsraten;

Figur 8  eine graphische Darstellung der Leistungsfähigkeit eines RCPTC's bei einem AWGN-Kanal für verschiedene Codierungsraten;

Figur 9  eine graphische Darstellung der Leistungsfähigkeit eines RCPTC's bei einem Rayleigh-Kanal bei unterschiedlichen Codierungsraten;

Figur 10  eine graphische Darstellung der Beziehung zwischen der Bitfehlerrate BER und der Varianz $\sigma^2_{LLR}$ am Ausgang des zweiten Decodierers; und

Figur 11  eine graphische Darstellung der Varianz $\sigma^2_{LLR}$ im Verhältnis zum Signal/Rausch-Verhältnis bei fehlerhaft beziehungsweise korrekt decodierten Paketen.

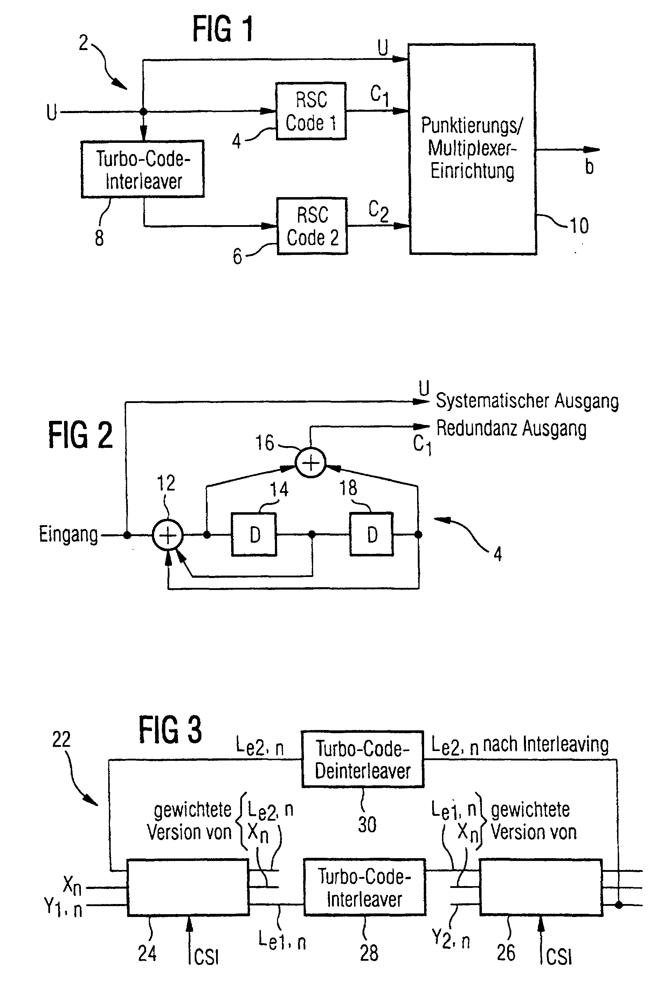

Im Hinblick auf einen ökonomischen Einsatz der Hardware sollte die ECC-Schaltung möglichst universell einsetzbar sein, während die ECC-Konfiguration durch eine Software-Steuerung eine hohe Flexibilität gestatten sollte. Der hier verwendete RCPTC ermöglicht dies, weil er die erforderliche Flexibilität aufweist. Der RCPTC kann mit dem in Figur 1 gezeigten Turbo-Codierer 2 erzeugt werden. Der Turbo-Codierer 2 weist $N_e$ = 2 binäre, rekursive, systematische Faltungscodierer 4, 6 (RSC) mit einer kleinen Constraint-Länge, beispielsweise zwischen 3 und 5, auf, die unter Verwendung eines Turbo-Interleavers 8 parallel geschaltet sind. Die Eingangssequenz u wird dem Codierer 4 (RSC, Code 1) und über den Turbo-Code-Interleaver 8 an den Codierer 6 (RSC, Code 2) sowie einer Punktierungs/Multiplexer-Einrichtung 10 zugeführt. Die Punktierungs/Multiplexer-Einrichtung erhält einen weiteren Eingang C1 von dem Codierer 4 und einen weiteren Eingang C2 von dem Codierer 6. Der Ausgang der Punktierungs/Multiplexer-Einrichtung 10 ist die Ausgangssequenz b.

Bei dem Turbo-Codierer 2 ist die minimale Coderate $R_c$, min gleich $1/(N_{e+1})$ = 1/3. Die minimale Codierungsrate $R_c$, min könnte weiter reduziert werden, indem zusätzliche RSC-Codierer eingesetzt werden.

Die binäre Eingangssequenz u, die eine endliche Zeitdauer hat, wird in den Codierer 4 eingegeben und ergibt an dessen Ausgang die Redundanzsequenz $C_1$ mit derselben endlichen Dauer wie u. Die Sequenz $u_I$, die die Sequenz u nach dem Interleaving darstellt, wird in den Codierer 6 gegeben. Die Codierung in dem Codierer 6 ergibt die Redundanzsequenz $C_2$. Die Redundanzsequenzen $C_1$ und $C_2$ und die Sequenz u werden punktiert und gemultiplext, um die Ausgangssequenz b zu bilden. Der Turbocodierer ist ein systematischer Codierer, wobei u die Basis der in b enthaltenen, systematischen Information ist.

Ein RSC-Codierer, wie er für die Codierer 4 und 6 verwendet werden kann, ist in Figur 2 am Beispiel des Codierers 4 dargestellt. An einem Eingang des Codierers 4 steht die Sequenz u als systematische Information an. Die Sequenz u gelangt über ein Additionsglied 12 zu einer Verzögerungsstufe 14 und einem weiteren Additionsglied 16. Die Ausgangssignale der Verzögerungsstufe 14 gelangt an eine zweite Verzögungsstufe 18 und an das Additionsglied 12. Die Ausgangssignale der zweiten Verzögerungsstufe 18 gelangen an die Additionsstufe 12 und die Additionsstufe 16. Der Ausgang der Additionsstufe ist dann die Reduntanzsequenz $c_1$.

Bei der Wahl dieses Codierers spielen die Hardwarekosten eine Rolle, die so niedrig wie möglich gehalten werden sollten. Aus diesem Grund sind die beiden RSC-Codierer zur Verwendung im Rahmen von FRAMES identisch und haben eine Constraint-Länge von 3. Obwohl diese RSC-Codierer nur vier Zustände haben, zeigen sie eine gute Leistungsfähigkeit bei niedrigen Werten des Signal/Rausch-Verhältnisses $E_b/N_0$. Daher ist die Leistungsfähigkeit desRCPTC's mit diesen Codierern bei niedrigen Signal-Rausch-Verhältnissen vorteilhaft.

Die Ausgangssequenz b des Turbo-Codierers 2 gelangt über den Übertragungskanal und einen Demodulator zu dem Turbo-Decodierer 22 (Figur 3), der einen RSC-Codierer 24 und einen zweiten RSC-Decodierer 26 aufweist. Zwischen einem Ausgang des Decodierers 24 und einem Eingang des Decodierers 26 ist ein Turbo-Code-Interleaver 28 vorgesehen. Zwischen einem Ausgang des Decodierers 26 und einem Eingang des Decodierers 24 ist ein Turbo-Code-Interleaver 30 vorgesehen. Die Decoder 24, 26 sind Soft-Input/Soft-Output-Decoder.

Der Demodulator (nicht gezeigt) liefert Schätzwerte $x_n$ der systematischen Information $u_n$, die in u enthalten sind, sowie Schätzwerte $y_{1,n}$ und $y_{2,n}$ der übertragenen Redundanzbits, die von den Codierern 4 beziehungsweise 6 erzeugt worden sind. Die beiden Decodierer 24, 26 benötigen eine Kanalzustandsinformation (CSI = Channel State Information), die aus den augenblicklichen Signalamplituden und der Rauschvarianz besteht. Jeder der Decodierer 24, 26 verarbeitet die systematische Information, die Redundanz und a-priori-Information $L_{e1,n}$ und $L_{e2,n}$ unter Verarbeitung der CSI, wodurch die extrinsische Information $L_{e2,n}$ und $L_{e1,n}$ erzeugt wird, die dann als a-priory-Wissen bei dem nachfolgenden Decodierer verwendet wird. Die Decodierung ist iterativ, und das Ergebnis der Decodierung wird mit jeder Iteration verbessert. Das Maß der Verbesserung nimmt jedoch allmählich mit der weiteren Iteration ab. Nach einer gewissen Anzahl von Iterationen wird das Ausgangssignal des Turbo-Decodierers 22 in einen Detektor (nicht gezeigt) zugeführt, wie es bei derartigen Übertragungssystemen üblich ist.

Um den Einsatz desRCPTC's auf die vorhandenen Diensterfordernisse anzupassen, könnte man daran denken, die RSC-Codierer anzupassen, was jedoch zu einer unerwünschten Mehrbelastung im Bezug auf die Hardwarekosten führen würde. Die Anpassung der Interleavergröße auf die speziellen Dienste ist an sich bekannt und stellt auch bei der Verwendung eines RCPTC's wegen dessen Flexibilität ein Problem dar.

Desweiteren kann die Zahl der Iterationen bei der Decodierung entsprechend dem QoS-Kriterium eingestellt werden unter Berücksichtigung der gesamten Codierungskomplexität. Zwei Möglichkeiten, um diese Eigenschaft des Turbocodes auszunutzen, sind an dem Empfänger gegeben. Für ein vorgegebenes QoS-Kriterium kann die Zahl der Iterationen mit ansteigendem Signal/Rausch-Verhältnis $E_b/N_0$ erhöht werden. Dies ist besonders vorteilhaft bei Fading-Kanälen, beispielsweise bei Übertragungskanälen. Andererseits kann die Zahl der Iterationen auch mit einem sich zeitlich ändernden QoS-Kriterium variiert werden. Die Einstellbarkeit der Zahl der Decodierungs-Iterationen ist nur bei der Verwendung von Turbo-Codes, insbesondere eines RCPTC's gegeben.

Eine weitere Möglichkeit die Leistungsfähigkeit in einem System mit einem RCPTC zu verbessern, besteht darin, die Punktierung einzustellen, so daß ein RCPTC mit variierenden Coderaten $R_{C,min} <= R_c <= R_{c,max}$ bereitgestellt werden können, wodurch die Codierungseigenschaften bei unveränderten Turbocode-Interleavern und RSC-Codierern geändert werden können.

Für die Punktierung stehen prinzipiell die Sequenzen u, $c_1$ und $c_2$ zu Verfügung. Wenn zwei der Sequenzen voll durch Punktierung unterdrückt werden, wird die maximale Coderate $R_{c,max} = 1$ angenommen. In diesem Fall hängen die Codierungseigenschaften davon ab, welche der Sequenzen punktiert werden. Wenn beispielsweise die Redundanzsequenzen $c_1$ und $c_2$ vollständig punktiert werden, wobei nur die Sequenz u unverändert durchgelassen wird, ist eine ECC nicht erhältlich, und Zeit Diversity-Gewinne sind an den Empfängern bei Fading-Kanälen nicht erreichbar. In diesem Fall reduziert sich der Turbo-Decodierer auf einen einfachen Schwellenwertdetektor.

Wenn eine der Redundanzsequenzen $C_1$ oder $C_2$ voll durch die Punktierung unterdrückt wird, wobei nur die zweite Redundanzsequenz zusammen mit der Sequenz u hindurchtreten kann, wird der Turbo-Codierer zu einem herkömmlichen RSC-Codierer. Der Turbo-Decodierer reduziert sich zu einem RSC-Decodierer, der zur Durchführung einer halben Iteration realisiert ist. Ein a-priori-Wissen basierend auf einer extrinsischen Information ist in diesem Fall nicht vorhanden. Die Codierungsrate $R_c$ kann zwischen % und 1 je nach dem QoS-Kriterium variiert werden. Da $N_e = 2$ gilt, können die RSC-Codierer auf zwei unterschiedlichen Codes basieren, und das QoS-Kriterium und die Codierungskomplexität können variiert werden, indem eine bestimmte Redundanzsequenz $C_1$ oder $C_2$ ohne Änderung der Codierungsrate $R_c$ unterdrückt wird.

Die oben erwähnten Möglichkeiten verhindern jedoch einen Turbo-Code-Betrieb, der nur zur Verfügung steht, wenn Bits von beiden Redundanzsequenzen $C_1$ und $C_2$ übertragen werden und gilt:

$$u_n \# u_{1,n}$$

wobei $u_n$ und $u_{1,n}$ in u beziehungsweise $u_1$ enthalten sind. In diesem Fall gilt:

$$R_{c,min} <= R_c < 1.$$

Die minimale Codierungsrate $R_{c,min} = 1/(N_e + 1)$ wird realisiert, wenn keine Punktierung durchgeführt wird. In diesem Fall kann entweder die herkömmliche RSC-Decodierung oder die Turbo-Decodierung realisiert werden, je nach dem QoS-Kriterium und Übertragungskanalzustand, wobei beide Faktoren bei Übertragungsanwendungen zeitlich variieren.

Bei echtem Turbo-Codebetrieb sind folgende Varianten möglich. Die Sequenz u wird nicht punktiert, die Redundanzsequenzen $c_1$ und $c_2$ werden teilweise punktiert. In diesem Fall ist ein Betrieb als RSC-Code oder als Turbo-Code möglich, die Zahl der Decodierungs-Iterationen ist einstellbar und die Codierungsrate kann zwischen 1/3 und 1 liegen. Diese Art der Punktierung wird Berrou's-Punktierung genannt.

Eine alternative Möglichkeit besteht darin, daß die Sequenz u und die Redundanzsequenzen $c_1$ und $c_2$ teilweise punktiert werden. In diesem Fall ist ein Betrieb mit RSC-Code nicht möglich, sondern nur mit einem Turbo-Code. Die Zahl der Decodierungs-Iterationen ist einstellbar, und die Codierungsrate kann zwischen 1/3 und 1 liegen. Diese Art der Punktierung wird UKL-Punktierung (UKL = University Kaiserslautern) genannt. Schließlich kann noch der Fall betrachtet werden, daß keine Punktierung stattfindet. In diesem Fall ist der Betrieb mit einem RSC-Code und einem Turbo-Code möglich. Die Zahl der Decodierungs-Iterationen ist einstellbar und die Codierungsrate liegt bei 1/3.

Das vorteilhafte Merkmal bei RCPTC liegt in der Möglichkeit, die Codierungsrate $R_c$ adaptiv zu ändern, wobei bei einem ARQ die erforderliche Information übertragen werden kann, ohne das gesamte, codierte Paket übertragen zu müssen. Die Übertragung eines zusätzlichen Teiles der Information, der die Differenz in der Codierungsrate ausgleicht, ist ausreichend.

Nachdem die Möglichkeiten der Anpassung der Codierung, im Fall von RCPTC beschrieben wurden, werden nun die Auswirkungen der Anpassungsmöglichkeiten auf die Leistungsfähigkeit des Systems bei Verwendung von RCPCT anhand von Simulationen beschrieben.

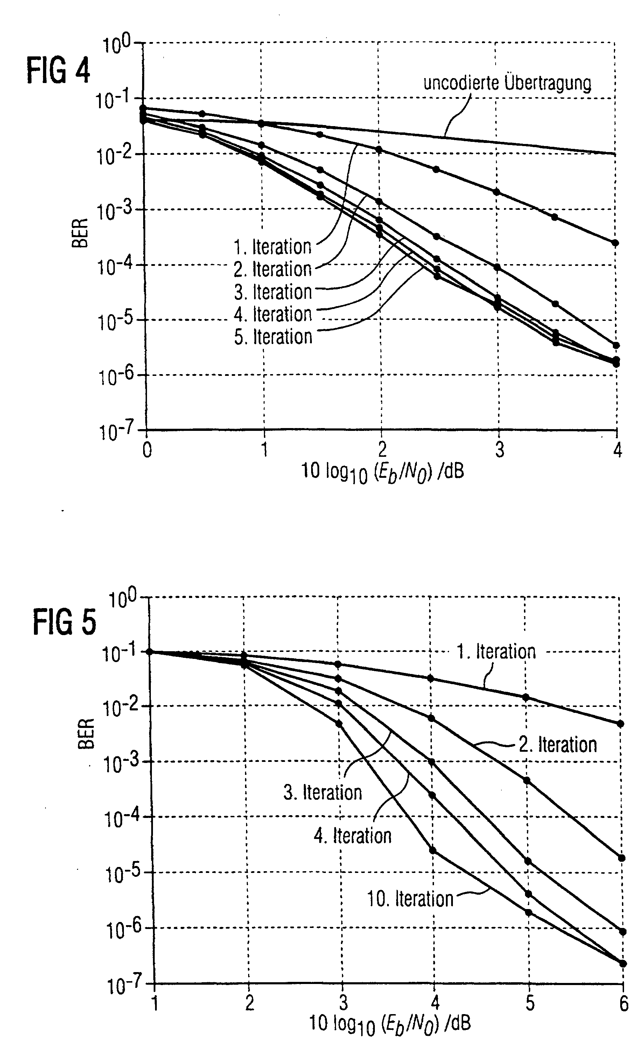

Figur 4 zeigt die Leistungsfähigkeit des RCPTC in einer graphischen Darstellung in der die Bitfehlerrate BER gegen das Signal/Rausch-Verhältnis $E_b/N_0$ für eine Sprachübertragung über einen AWGN-Kanal dargestellt ist. Die Paketgröße war 150 bit, und die Codierungsrate etwa = 1/3. Die Trägerdatenrate für die Sprachübertragung betrug 8 = kbit/s. Die uncodierte Übertragung wird als Bezugslinie gezeigt. Der Parameter dieser Simulationen ist die Zahl der Decodierungs-Iterationen, die zwischen 1 und 5 variiert. Nach der ersten Decodierungs-Iteration ist das minimale Signal/Rausch-Verhältnis, das erforderlich ist, um eine Bitfehlerrate von $< 10^{-3}$ zu erreichen, etwa gleich 3,5 dB. Nach der zweiten Decodierungs-Iteration ist etwa 1,3 dB weniger erforderlich. Die nächste Decodierungs-Iteration ermöglicht einen weiteren Gewinn von 0,2 dB. Die nächsten Iteration ermöglichen Gewinne von weniger als 0,1 dB. Nach fünf Iterationen ist das minimale Signal/Rausch-Verhältnis, das für eine Bitfehlerrate von weniger als $10^{-3}$ erforderlich ist, etwa gleich 1,8 dB. Es ist demnach ersichtlich, daß die Leistungsverbesserung mit zunehmender Iterationen weniger wird. Im Vergleich erfordert ein herkömmlicher NSC-Code mit einer Constraint-Länge von 9 etwa 1,9 dB, um dieselbe Bitfehlerrate von $< 10^{-3}$ zu erreichen. Der RCPTC ist daher etwas leistungsfähiger als herkömmliche Codes selbst bei so kleinen Paketgrößen wie 150 bit.

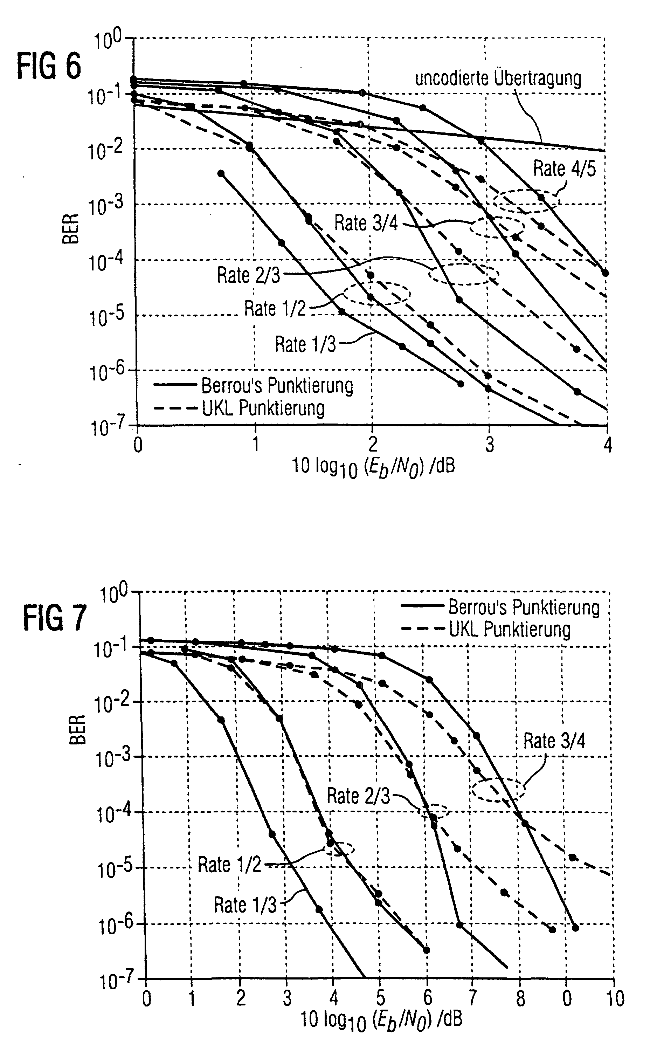

Figur 5 zeigt die Leistungsfähigkeit des RCPTC in einer graphischen Darstellung, in der die Bitfehlerraten BER gegen das Signal/Rausch-Verhältnis $E_B/N_0$ für Schmalband-ISDN bei einer Trägerdatenrate von 144 kbit/S, einer Paketgröße von 672 bit, einer Coderate von etwa ½ und einem voll einem Interleaving unterzogenen Rayleigh-Fading-Kanal gezeigt ist. Der Simulationsparameter ist wiederum die Zahl der Decodierungs-Iterationen. Nach vier Decodierungs-Iterationen erfordert eine Bitfehlerrate von weniger als $10^{-3}$ ein minimales Signal/Rausch-Verhältnis von 3,8 dB. Nach zehn Iterationen sind nur noch etwa 3,4 dB erforderlich. Ein herkömmlicher NSC-Code mit einer ähnlichen Decodierungskomplexität wie vier Decodierungs-Iterationen hat einen Constraint-Länge von 8 und erfordert ein um 1,1 dB höheres Signal/Rausch-Verhältnis.

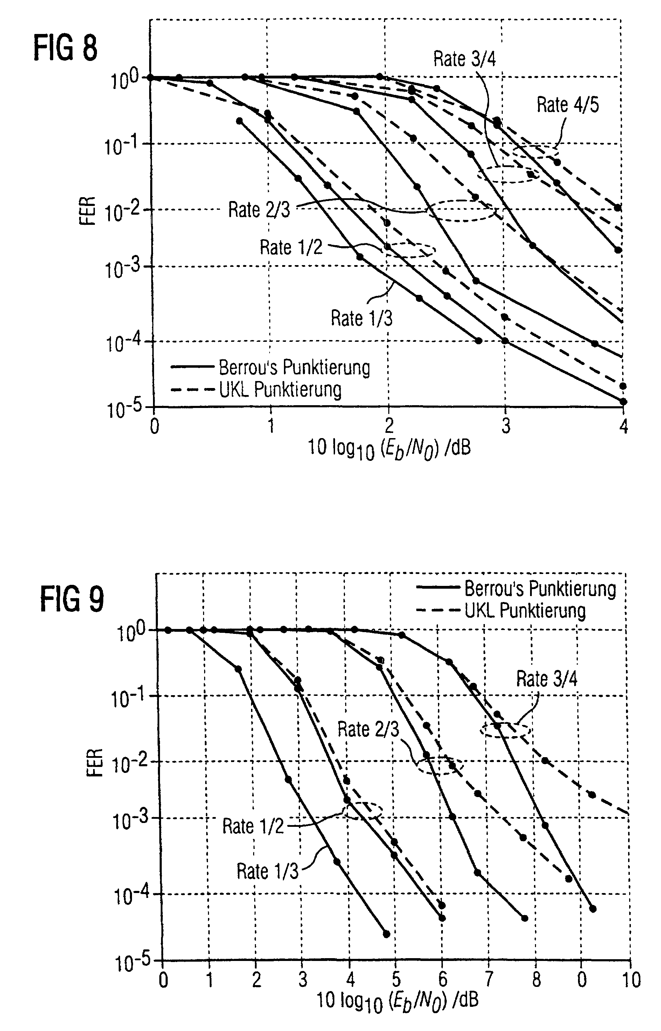

Die Figuren 6 bis 9 zeigen graphische Darstellungen für die Leistungsfähigkeit bei Verwendung von RCPTC, wobei die Bitfehlerrate BER beziehungsweise die Rahmenfehlerrate FER gegen das Signal/Rausch-Verhältnis $E_B/N_0$ aufgetragen ist. Figur 6 zeigt die Bitfehlerrate gegen das Signal/Rausch-Verhältnis bei einer Paketgröße von 672 bit, zehn Decodierungs-Iterationen und einem AWGN-Kanal. Figur 7 zeigt die Bitfehlerrate gegen das Signal/Rausch-Verhältnis bei einer Paketgröße von 672 bit, zehn Decodierungs-Iterationen und einem voll einem Interleaving unterworfenen Rayleigh-Fading-Kanal. Figur 8 zeigt die Rahmenfehlerrate FER gegen das Signal/Rausch-Verhältnis bei einer Paketgröße von 672 bit,zehn Decodierungs-Iterationen und einem AWGN-Kanal. Figur 9 zeigt die Rahmenfehlerrate gegen das Signal/Rausch-Verhältnis bei einer Paketgröße von 672 bit, 10 Decodierungs-Iterationen und einem voll einem Interleaving unterworfenen Rayleigh-Fading-Kanal. In den graphischen Darstellungen der Figuren 6 bis 9 werden zwei unterschiedliche Punktierungsverfahren angewendet, nämlich die Berrou's-Punktierung und die UKL-Punktierung, die oben erwähnt wurden. Es ist ersichtlich, daß die Berrou's-Punktierung eine bessere Leistungsfähigkeit bei geringeren Werten des Signal/Rausch-Verhältnisses hat, während die UKL-Punktierung bei einem hohen Signal/Rausch-Verhältnis und daher bei Bitfehlerraten von < $10^{-4}$ vorteilhaft ist. Die Kreuzungspunkte bewegen sich in Richtung auf niedrigere Bitfehlerraten bei wachsenden Codierungsraten.

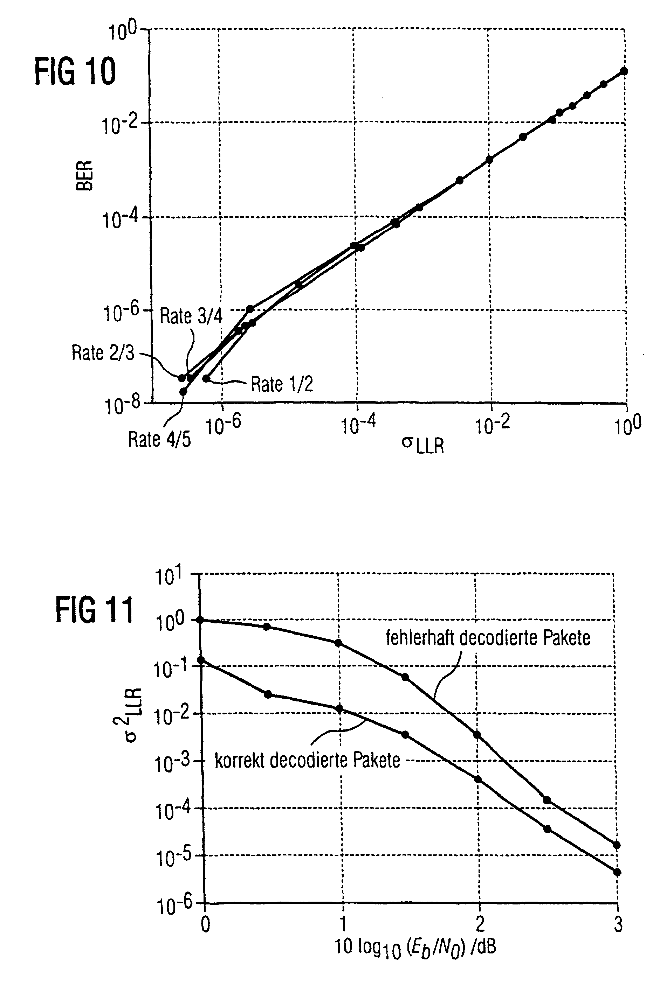

In Figur 10 ist die Bitfehlerrate gegen die Varianz der log-Likelihood-Verhältnisse (LLR = Log-Likelihood Ratio) an dem Ausgang des zweiten Decodierers gezeigt, wobei ein RCPTC, eine Paketgröße von 372 bit, zehn Decodierungs-Iterationen und ein AWGN-Kanal angenommen wird. Aus dieser Figur ist ersichtlich, daß die Codierungsrate keinen Einfluss auf die Beziehung zwischen der Bitfehlerrate und der Varianz $\sigma^2_{LLR}$ hat, weil diese beiden Größen eine ähnliche Abhängigkeit von dem Signal/Rausch-Verhältnis $E_B/N_0$ haben. Daher kann, wenn $\sigma^2_{LLR}$ bekannt ist, eine Abschätzung der Bitfehlerrate leicht durchgeführt werden, deren Ergebnis als Basis für eine Aktion dienen kann, beispielsweise für eine Anpassung der Decodierungs-Iterationszahl oder der Codierungsrate zur Verbesserung der Übertragungsqualität oder, im Falle von ARQ, zur Anforderung einer erneuten Sendung eines fehlerhaft codierten Pakets.

Schließlich zeigt Figur 11 die Varianz $\sigma^2_{LLR}$ des Log-Likelihood-Verhältnisses LLR am Ausgang des zweiten Decodierers im Verhältnis zu dem Signal/Rausch-Verhältnis $E_B/N_0$ bei Verwendung von RCPTC mit einer Paketgröße von 600 bit, einer Coderate von etwa 5/9, zehn Decodierungs-Iterationen und einem AWGN-Kanal. Der RCPTC war für einen 64 kbit/S-Trägerservice ausgelegt. Aus Figur 11 ergibt sich, daß eine ähnliche Überlegung wie im Zusammenhang mit Figur 10 auch für die Abhängigkeit der Varianz $\sigma^2_{LLR}$ von dem Auftreten von Paketfehlern zutrifft. $\sigma^2_{LLR}$ ist bei fehlerhaft decodierten Paketen immer größer als $\sigma^2_{LLR}$ im Falle von korrekt decodierten Paketen. Wenn daher das Signal/Rausch-Verhältnis $E_B/N_0$ und $\sigma^2_{LLR}$ für ein gerade überprüftes Paket bekannt sind, kann eine Soft-Decision-Variable, die mit der Wahrscheinlichkeit eines Paketfehlers in Beziehung steht, leicht erzeugt und zu Steuerungszwecken eingesetzt werden.

Obwohl sich die vorliegende Beschreibung hauptsächlich auf die Anwendung der Erfindung auf den digitalen Mobilfunk bezieht, ist die Erfindung nicht darauf beschränkt sondern kann allgemein bei digitalen Übertragungssystemen, beispielsweise bei leistungsgebundenen Systemen, optischen Übertragunssystemen (Infrarot-und Laser-Übertragunssysteme), Satellitenfunksystemen, Deep-Space-Übertragunssystemen, Richtfunk-Übertragunssystemen und Rundfunk-Übertragunssystemen (Digitales Radio oder TV), mit den genannten Vorteilen eingesetzt werden.

**Patentansprüche**

1. Verfahren zur Datenübertragung in einem digitalen Übertragungssystem bei paketvermitteltem Dienst, bei dem zur Kanalcodierung senderseitig in einem Turbo-Codierer eine Turbo-Codierung und empfängerseitig in einem Turbo-Decodierer eine Turbo-Decodierung mit Soft-Decision-Ausgangssignalen durchgeführt wird, **dadurch gekennzeichnet, daß** zur Auslösung eines ARQ

   - die Kanalgüte durch ein an sich bekanntes Parameterschätzverfahren abgeschätzt wird, daß
   - die Varianzen der Soft-Decision-Ausgangssignale an dem Turbo-Decodierer bestimmt werden, daß
   - aus der Kanalgüte und den Varianzen auf die Korrektheit beziehungsweise Fehlerhaftigkeit des übertragenen Paketes geschlossen wird, und daß
   - eine erneute Sendung wenigstens eines Teiles eines fehlerhaften Paketes ausgelöst wird.

2. Verfahren nach Anspruch 1, wobei empfängerseitig ein Soft-Input/Soft-Output- Symbol oder -Sequenzschätzer verwendet wird, **dadurch gekennzeichnet, daß** die Dienstqualität aus den Varianzen $\sigma^2$ der Soft-Decision-Ausgangssignale des Turbo-Decodierers bestimmt wird.

3. Verfahren nach Anspruch 2,
   **dadurch gekennzeichnet,**
   **daß** aus den Varianzen $\sigma^2$ die Bitfehlerrate als Maß für die Dienstqualität berechnet wird.

4. Verfahren nach Anspruch 2, wobei empfängerseitig ein MAP-Symbolschätzer oder ein MAP-Sequenzschätzer verwendet wird,
   **dadurch gekennzeichnet,**
   **daß** die Dienstqualität aus den Varianzen $\sigma^2_{LLR}$ der Soft-Decision-Ausgangssignale des Turbo-Decodierers bestimmt wird.

5. Verfahren nach Anspruch 2, wobei empfängerseitig ein Viterbi-Algorithmus zur Sequenzschätzung verwendet wird,
**dadurch gekennzeichnet,**
**daß** die Dienstqualität aus den Varianzen $\sigma^2_{VIT}$ der Soft-Decision-Ausgangssignale des Turbo-Decodierers bestimmt wird.

6. Verfahren nach einem der vorhergehenden Ansprüche,
**dadurch gekennzeichnet,**
**daß** zur Punktierung eine sogenannte Berrou's Punktierung eingesetzt wird, bei der nur die nicht-systematische Information punktiert wird.

7. Verfahren nach einem der Ansprüche 1 bis 5,
**dadurch gekennzeichnet,**
**daß** zur Punktierung eine sogenannte UKL-Punktierung eingesetzt wird, bei der sowohl die systematische als auch die nicht-systematische Information punktiert wird.

8. Verfahren nach einem der vorhergehenden Ansprüche,
**dadurch gekennzeichnet,**
**daß** als Turbo-Code ein RCPTC verwendet wird.

9. Verfahren nach einem der vorhergehenden Ansprüche,
**dadurch gekennzeichnet,**
**daß** bei einer erneuten Übertragung der Information eines fehlerhaften Paketes wenigstens ein Teil der durch die Punktierung des RCPTC's bei der vorherigen Sendung unterdrückten Information gesendet wird, und daß diese zusätzliche Information empfängerseitig in die bereits vorhandene Information eingefügt und diese vollständige Information erneut decodiert wird.

10. Verfahren nach Anspruch 9,
**dadurch gekennzeichnet,**
**daß** bei der erneuten Sendung nur die Bits gesendet werden, die bei der nächstniedrigeren Codierungsrate zusätzlich zur Verfügung stehen, da sie nicht punktiert werden.

11. Verfahren nach Anspruch 9 oder 10,
**dadurch gekennzeichnet,**
**daß** das Verfahren wiederholt wird, bis eine fehlerfreie Decodierung des Paketes erfolgt ist oder die gesamte codierte Information eines Paketes übertragen ist.

**Claims**

1. Method for data transmission in a digital transmission system for a packet-switching service, in which, for channel coding, turbo coding is carried out in a turbo coder at the transmitter end, and turbo decoding with soft-decision output signals is carried out in a turbo decoder at the receiver end, **characterized in that**, in order to initiate an ARQ

- the channel quality is estimated by means of a parameter estimation method which is known per se, **in that**
- the variances of the soft-decision output signals are determined at the turbo decoder, **in that**
- the correctness or erroneous nature of the transmitted packet is deduced from the channel quality and the variances, and **in that**
- a renewed transmission of at least a part of an erroneous packet is initiated.

2. Method according to Claim 1, with a soft-input/soft-output symbol or sequence estimator being used at the receiver end,
**characterized in that** the quality of service is determined from the variances $\sigma^2$ of the soft-decision output signals from the turbo decoder.

3. Method according to Claim 2,
**characterized**
**in that** the bit error rate is calculated, as a measure of the quality of service, from the variances $\sigma^2$.

4. Method according to Claim 2, with a MAP symbol estimator or a MAP sequence estimator being used at the receiver end,
**characterized**
**in that** the quality of service is determined from the variances $\sigma^2_{LLR}$ of the soft-decision output signals from the turbo decoder.

5. Method according to Claim 2, with a Viterbi algorithm being used for sequence estimation at the receiver end,
**characterized**
**in that** the quality of service is determined from the variances $\sigma^2_{VIT}$ of the soft-decision output signals from the turbo decoder.

6. Method according to one of the preceding claims,
**characterized**
**in that** what is referred to as Berrou's puncturing is used for puncturing, in which only the non-systematic information is punctured.

7. Method according to one of Claims 1 to 5,
**characterized**
**in that** what is referred to as UKL puncturing is used for puncturing, in which both the systematic information and the non-systematic information are punctured.

8. Method according to one of the preceding claims,

**characterized**
**in that** an RCPTC is used as the turbo code.

9. Method according to one of the preceding claims, **characterized**
**in that**, when the information in an erroneous packet is transmitted once again, at least some of the information suppressed by the puncturing of the RCPTCs in the previous transmission is transmitted, and in that this additional information is inserted into the already available information at the receiver end, and this complete information is decoded once again.

10. Method according to Claim 9, **characterized**
**in that**, when a repeated transmission is made, the only bits which are transmitted are those which are additionally available at the next-lower coding rate, since they are not punctured.

11. Method according to Claim 9 or 10, **characterized**
**in that** the method is repeated until the packet is decoded without any errors, or all the coded information in a packet is transmitted.

**Revendications**

1. Procédé pour la transmission de données dans un système de transmission numérique en service de commutation par paquets, dans lequel pour le codage de la voie de transmission, un turbo-décodage est réalisé dans un turbo- codeur, côté émetteur et un turbo-décodage avec signaux de sortie à décision souple est réalisé dans un turbo-décodeur, côté récepteur, **caractérisé en ce que**, pour la libération d'une DAR

   - la qualité de la voie de transmission est estimée par un procédé d'estimation des paramètres, connu en soi, **en ce que**
   - les variances des signaux de sortie à décision souple sont déterminées au turbo-décodeur, **en ce que**
   - l'exactitude respectivement la défectuosité du paquet transmis est déduite de la qualité de la voie de transmission et des variances et **en ce que**
   - une nouvelle émission d'une partie au moins d'un paquet défectueux est déclenchée.

2. Procédé selon la revendication 1, dans lequel un estimateur de symboles ou de séquences soft input/soft output est utilisé, **caractérisé en ce que** la qualité du service est déterminée à partir des variances $\sigma^2$ des signaux de sortie à décision souple du turbo-décodeur.

3. Procédé selon la revendication 2, **caractérisé en ce que** le taux d'erreurs binaires est calculé à partir des variances $\sigma^2$, en tant que dimension pour la qualité du service.

4. Procédé selon la revendication 2, dans lequel un estimateur de symboles MAP ou un estimateur de séquences MAP est utilisé côté récepteur, **caractérisé en ce que** la qualité du service est déterminée à partir des variances $\sigma^2{}_{LLR}$ des signaux de sortie à décision souple du turbo-décodeur.

5. Procédé selon la revendication 2, dans lequel un algorithme de Viterbi est utilisé côté récepteur pour l'estimation de la séquence, **caractérisé en ce que** la qualité du service est déterminée à partir des variances $\sigma^2{}_{VIT}$ des signaux de sortie à décision souple du turbo-décodeur.

6. Procédé selon l'une quelconque des revendications précédentes, **caractérisé en ce que** le dénommé pointillage de Berrou, qui consiste à pointiller uniquement l'information non systématique, est utilisé pour le pointillage.

7. Procédé selon l'une quelconque des revendications 1 à 5, **caractérisé en ce que** le dénommé pointillage UKL, qui consiste à pointiller aussi bien l'information systématique que l'information non systématique est utilisé pour le pointillage.

8. Procédé selon l'une quelconque des revendications précédentes, **caractérisé en ce qu'**un RCPTC est utilisé en tant que turbo-décodeur.

9. Procédé selon l'une quelconque des revendications précédentes, **caractérisé en ce que**, lors d'une nouvelle transmission de l'information d'un paquet erroné, au moins une partie de l'information qui a été supprimée par le pointillage du RCPTC lors de l'envoi précédent est envoyée et **en ce que**, côté récepteur, cette information supplémentaire est intégrée dans l'information préalablement existante et **en ce que** cette nouvelle information est entièrement décodée.

10. Procédé selon la revendication 9, **caractérisé en ce que**, lors du nouvel envoi, seuls les bits qui sont disponibles pour le taux de codage immédiatement inférieur sont disponibles en supplément, car ils ne subissent aucun pointillage.

11. Procédé selon l'une quelconque des revendications 9 ou 10, **caractérisé en ce que** la procédure se répète jusqu'à ce que le paquet soit décodé sans erreur ou jusqu'à ce que l'information codée complète d'un paquet soit transmise.

## FIG 1

2

U

RSC Code 1 → $C_1$

4

Turbo-Code-Interleaver

8

RSC Code 2 → $C_2$

6

Punktierungs/ Multiplexer- Einrichtung → b

U

10

## FIG 2

U Systematischer Ausgang

Redundanz Ausgang $C_1$

16

12

14   18

Eingang

D   D

4

## FIG 3

22

$L_{e2,n}$    Turbo-Code- Deinterleaver    $L_{e2,n}$ nach Interleaving

gewichtete Version von $\{L_{e2,n} \, X_n\}$

30

$L_{e1,n}\{X_n\}$ gewichtete Version von

$X_n$
$Y_{1,n}$

Turbo-Code- Interleaver

24  CSI    $L_{e1,n}$    28    $Y_{2,n}$   26   CSI

FIG 4

BER

$10 \log_{10} (E_b/N_0)$ /dB

uncodierte Übertragung
1. Iteration
2. Iteration
3. Iteration
4. Iteration
5. Iteration

FIG 5

BER

$10 \log_{10} (E_b/N_0)$ /dB

1. Iteration
2. Iteration
3. Iteration
4. Iteration
10. Iteration

FIG 6

FIG 7

**FIG 8**

**FIG 9**

FIG 10

BER

Rate 3/4
Rate 2/3
Rate 1/2
Rate 4/5

$\sigma_{LLR}$

FIG 11

$\sigma^2_{LLR}$

fehlerhaft decodierte Pakete

korrekt decodierte Pakete

$10 \log_{10} (E_b/N_0)$ /dB